# EUROPÄISCHE PATENTSCHRIFT

(11) **EP 4 069 459 B1**
(45) Veröffentlichungstag und Bekanntmachung des Hinweises auf die Patenterteilung: **07.08.2024**
(21) Anmeldenummer: 20817267.6
(22) Anmeldetag: 01.12.2020
(51) Int. Cl.: B23K 1/00, B23K 1/19, B23K 1/20, H01L 23/10, H05K 3/34, B23K 101/36

(54) **VERFAHREN ZUM FÜGEN MINDESTENS EINES ERSTEN UND EINES ZWEITEN FÜGEBEREICHS, FÜGEVERBINDUNG UND ELEKTRONISCHE KOMPONENTE SOWIE SCHALTUNGSANORDNUNG**
METHOD FOR JOINING AT LEAST ONE FIRST AND ONE SECOND JOINING REGION, JOINT AND ELECTRONIC COMPONENT AND CIRCUIT ARRANGEMENT
PROCÉDÉ DE JONCTION D'AU MOINS UNE PREMIÈRE ET UNE SECONDE ZONE DE JONCTION, JOINT AINSI QUE COMPOSANT ÉLECTRONIQUE ET ENSEMBLE CIRCUIT

(30) Priorität: 04.12.2019 DE 102019218866
(43) Veröffentlichungstag der Anmeldung: 12.10.2022
(73) Patentinhaber: Albert-Ludwigs-Universität Freiburg, 79098 Freiburg (DE)
(72) Erfinder: STIEGLITZ, Thomas, 79110 Freiburg (DE); LANGENMAIR, Michael, 79108 Freiburg (DE)
(74) Vertreter: Grünecker Patent- und Rechtsanwälte PartG mbB
(86) Internationale Anmeldenummer: PCT/EP2020/084006
(87) Internationale Veröffentlichungsnummer: WO 2021/110619

(56) Entgegenhaltungen:
- FR-A1- 2 306 528
- US-A- 4 011 981
- US-A- 4 509 880
- US-A- 4 895 291
- US-A1- 2002 100 986
- US-B1- 9 508 676

## Beschreibung

Die vorliegende Erfindung bezieht sich auf ein Verfahren zum Fügen mindestens eines ersten und eines zweiten Fügebereichs, eine entsprechende Fügeverbindung und eine elektronische Komponente mit mindestens einer derartigen Fügeverbindung und eine Schaltungsanordnung mit einer gekapselten elektronischen Komponente entsprechend dem Oberbegriff der Ansprüche 1, 5, 8 und 15 (siehe z.B. US4011981 A).

Jüngste Forschung und Entwicklung auf dem Gebiet der Neurotechnik ("Neural Engineering") führten zu einer Vielzahl von aktiven implantierbaren medizinischen Geräten (Active Implantable Medical Device, AIMD), die in einem weiten Anwendungsbereich einsetzbar sind. Diese bestehen üblicherweise aus einem Gehäuse, das eine Steuerelektronik und eine Batterie beinhaltet, implantierbaren Elektroden (oder Elektrodenarrays) und Kabeln für die elektrische Kontaktierung der Elektroden und der Elektronik. Die Elektroden werden für die elektrische Stimulierung von Zellen oder das Erfassen von physiologischen Signalen verwendet.

Reintitan und Titanlegierungen (v.a. Ti Al6 V4) sind weit verbreitete Materialien in der Chemischen Industrie, im Transportwesen und der Medizintechnik. Titan und die verwendeten Legierungen sind hochinerte Materialien, wie beispielsweise in dem Artikel A. Muhrat, H. Puga, and J. Barbosa, "Low-Temperature Brazing of Titanium Using Al-Based Filler Alloys," Advances in Materials Science and Engineering, vol. 2018, no. 2, pp. 1-16, 2018, ausgeführt. An dieser Stelle sei bezüglich der Nomenklatur angemerkt, dass Legierungen generell entweder so bezeichnet werden, dass die Elementsymbole in der Reihenfolge ihres Gewichtsanteils an der Legierung nacheinander geschrieben werden. Dabei wird üblicherweise nach jedem Symbol (in der Regel außer dem Hauptbestandteil) eine Zahl geschrieben, die den Gewichtsprozent, mit denen die jeweilige Komponente beteiligt ist, entspricht. Alternativ kann diese Gewichtsprozentangabe auch vor der jeweiligen Komponente erfolgen, wobei die einzelnen Komponenten durch Trennstriche separiert werden. Die Angabe Ti Al6 V4 oder Ti-6Al-4V bezeichnet mithin eine Legierung mit 90 Gewichtsprozent Titan, 6 Gewichtsprozent Aluminium und 4 Gewichtsprozent Vanadium.

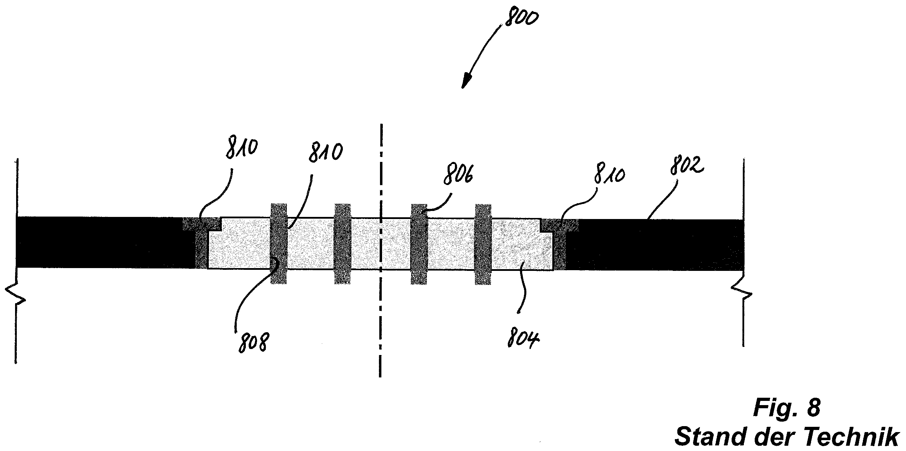

Titan und Titanlegierungen werden beispielsweise in der Medizintechnik häufig als hermetisches Gehäuse für elektrische Systeme eingesetzt. Diese aktiven implantierbaren medizinischen Geräte wie z. B. Herzschrittmacher müssen elektrische Signale aus dem Inneren der Titangehäusung in den Körper einbringen. Das ist nur möglich, wenn die einzelnen elektrischen Kanäle durch ein elektrisch isolierendes Material voneinander und von der (elektrisch leitfähigen) Titangehäusung getrennt sind. Dafür müssen in die Titangehäusung elektrisch isolierende Materialien eingelassen und hermetisch abgeschlossen werden. Figur 8 zeigt schematisch einen Ausschnitt aus einem bekannten implantierbaren Gehäuse 800. Das Gehäuse 800 weist ein erstes Gehäuseelement 802 und ein zweites Gehäuseelement 804 auf. Das erste Gehäuseelement 802 ist dabei aus Titan oder einer Titanlegierung und bildet einen Hohlkörper, in welchem z. B. die elektronischen Bauelemente eines Herzschrittmachers aufgenommen sind (in den Figuren nicht dargestellt). Das zweite Gehäuseelement 804 ist üblicherweise aus Keramik hergestellt.

Eine Vielzahl von Verbindungsleitungen 806 muss durch das Gehäuse 800 hindurchgeführt werden, damit z. B. Elektroden Anregungssignale nach außen führen können oder Messsignale an die elektronischen Bauelemente nach innen geleitet werden können. Zu diesem Zweck sind in dem zweiten Gehäuseelement 804 Leitungsdurchführungen 808 vorgesehen. Für einen einwandfreien Betrieb muss das Gehäuse 800 die im Inneren befindlichen elektronischen Bauelemente hermetisch kapseln. Daher muss sowohl der Verbindungsbereich zwischen dem ersten und dem zweiten Gehäuseelement 802, 804 wie auch zwischen den Leitungsdurchführungen 808 und den Verbindungsleitungen 806 hermetisch dicht sein.

Bisher werden die hermetischen Verbindungen von Titan oder Titanlegierungen des ersten Gehäuseelements 802 zu Fügepartnern wie z. B. Keramiken und elektrischen Durchführungen aufwändig in Hochtemperaturverfahren mit teuren Metalllegierungen 810 realisiert, wie dies beispielsweise aus der Patentschrift US 6 575 353 B2 bekannt ist.

Das Fügen von Titan und Titanlegierungen an keramische Materialien wird insbesondere bisher bei Brennvorgängen über 700 °C realisiert. Dabei entsteht jedoch eine Vielzahl von Problemen.

Zum einen müssen an die Ofenatmosphäre hohe Anforderungen gestellt werden. Das Fügeverfahren muss unter Hochvakuum durchgeführt werden um Oxidation und Nitrierung zu vermeiden, wie dies z. B. aus dem Artikel E. Gemelli and N.H.A. Camargo, "Oxidation kinetics ofcommercially pure titanium," Biomaterials, vol. 12, no. 3, pp. 525-531, 2007, bekannt ist. Alle Fügepartner müssen dabei hochtemperaturstabil und hochvakuumstabil sein.

Darüber hinaus werden mechanische Verspannungen in die Fügestelle eingebracht. Daher müssen die thermischen Ausdehnungskoeffizienten der Fügepartner exakt aneinander angeglichen sein (siehe die Dissertation Ho-Rim Lee, "Comparative Study of Bond Characteristics between Titanium/Titanium Alloy and Ceramic," Inaugural-Dissertation, Medizinischen Fakultät, Eberhard-Karls-Universität, Tübingen, 2004).

Einige bekannte Verbindungsverfahren erfordern Temperaturen von über 1000 °C. Dabei wird die Phasenzusammensetzung von Titan und Titanlegierungen verändert, auch wenn die eigentliche Schmelztemperatur der Basismaterialien höher liegt.

Wie dies bekannt ist (siehe z. B. E. Gemelli and N.H.A. Camargo, "Oxidation kinetics of commercially pure titanium," Biomaterials, vol. 12, no. 3, pp. 525-531, 2007), weist Titan immer eine native Oxidschicht von einigen nm auf. Bei hohen Temperaturen diffundiert dieses Oxid in das Basismaterial und schwächt dadurch das Basismaterial (siehe wiederum die Dissertation Ho-Rim Lee, "Comparative Study of Bond Characteristics between Titanium/Titanium Alloy and Ceramic," Inaugural-Dissertation, Medizinischen Fakultät, Eberhard-Karls-Universität, Tübingen, 2004).

Die üblicherweise verwendeten Metallpasten, die zum Fügen im heterogenen Verbund (z. B. beim Fügen des Basismaterials Titan an eine Aluminiumoxidkeramik als Fügepartner) eingesetzt werden, sind circa hundertmal teurer als die erfindungsgemäß verwendeten Zinnverbindungen.

Die bei bekannten Anordnungen verwendeten Metallpasten zum Fügen im heterogenen Verbund stellen darüber hinaus sehr hohe Anforderungen an das Design der Fügestellen. Spaltmaße, Füllmenge, Temperaturkurven beim Brennen und das Ausgleichen von thermischen Spannungen müssen dabei in aufwendiger Weise berücksichtigt werden.

Wie bereits erwähnt, bilden sich auf Titanoberflächen native Oxide, die einer Ausbildung einer stabilen Weichlotverbindung bei Löttemperaturen von weniger als 450 °C entgegenstehen (siehe z. B. die Patentschrift US 6 659 329 B1). Daher werden Weichlotverbindungen auf Titan oder Titanlegierungen bislang zum einen nach chemischer Vorbehandlung des Basismaterials mit anschließender galvanischer Abscheidung von Kupfer oder Silber hergestellt (siehe z. B. Deutsche Titan, Nov. 2004, "Hinweise zum Löten von Titan und Titanlegierungen", online abrufbar unter https://www.isoarc.ch/info-datenbank/pdf/Loeten_von_Titan.pdf, abgerufen am 27. November 2019). Allerdings sind weder Kupfer noch Silber biokompatibel und diese bekannte Lötverbindung hat den Nachteil einer mangelnden Langzeitstabilität in feuchter Umgebung.

Aus der offengelegten Patentanmeldung US 2005/0072837 A1 ist weiterhin bekannt, aggressive Flussmittel zu verwenden, um dieses Problem zu lösen. Solche aggressiven Flussmittel sind jedoch nicht für den Einsatz in der Medizintechnik geeignet, da verbleibende Flussmittelreste toxische Eigenschaften aufweisen und Korrosion an der Fügestelle begünstigen, wie dies aus der Patentschrift US 6 659 329 B1 bekannt ist.

US 4 895 291 A offenbart ein Verfahren zur Herstellung einer hermetischen Abdichtung für ein Festkörperbauelement. Die Vorrichtung umfasst ein Keramikgehäuse mit einem Hohlraum für ein Element wie einen Bildsensor. Ein aus einem transparenten Material gebildeter Deckel ist mit dem Gehäuse versiegelt, um den Hohlraum zu schließen. Ein Metallisierungsträger ist auf dem Deckel und dem Gehäuse ausgebildet. Um eine hermetische Abdichtung bei einer relativ niedrigen Temperatur zu erreichen, wird eine Indiumschicht auf den Metallisierungsträger entweder des Deckels oder des Gehäuses und eine Zinnschicht auf den Träger des anderen der beiden Teile aufgebracht. Dann wird der Deckel auf das Gehäuse gesetzt und die Teile werden in einen Ofen gelegt, in dem eine Temperatur unterhalb der Schmelztemperatur der Verbundlegierung aus Zinn und Indium lange genug gehalten wird, um Zinn und Indium zusammen zu diffundieren. Die Temperatur wird dann auf eine Temperatur erhöht, die ausreicht, um die Legierung zu schmelzen, und das Gerät wird dann langsam auf Umgebungstemperatur abgekühlt.

US 4 509 880 A bezieht sich auf eine hochhermetische Glas-Metall-Dichtung, umfassend ein rundes, zylindrisch geformtes Glaselement mit einem Außendurchmesser; eine röhrenförmige Hülse aus elastischem Metall mit (i) einem ersten Ende mit einem Innendurchmesser, der etwas größer ist als der Außendurchmesser des Glaselements, und (ii) einem Abschnitt mit reduziertem Durchmesser, der an das erste Ende davon angrenzt, wobei der Durchmesser des Abschnitts mit reduziertem Durchmesser etwas kleiner ist als der Außendurchmesser des Glaselements; eine dünne metallisierte Schicht auf einem ersten Ende des Glaselementes, die dazu geeignet ist, in das erste Ende der rohrförmigen Metallhülse eingeführt zu werden, um einen ringförmigen Spalt dazwischen zu definieren, wobei das Glaselement so weit wie möglich in die Hülse eingeführt wird, so dass sein Ende in einer anstoßenden Beziehung mit dem Abschnitt mit reduziertem Durchmesser der Hülse steht, um einen Kapillarspalt dazwischen zu bilden. Anschließend wird ein Lötmittel in geschmolzener Form in den ringförmigen Spalt gemäß einer ziehenden Kraft in den Kapillarspalt geflossen, so dass, wenn das Lötmittel abkühlt, eine hochhermetische Glas-Metall-Dichtung entsteht.

Die FR 2 306 528 A1 offenbart ein Verfahren zum Bleilöten. Insbesondere zeigt die Druckschrift eine Verbindung zwischen einem hochschmelzenden Metall und einem Halbleiter mittels eines duktilen Metalls. Ein Verfahren zu deren Herstellung schließt die Bildung einer Schicht aus einem Benetzungsmittel für hochschmelzendes Metall, wie Titan, auf dem hochschmelzenden Metall vor dem Verbinden ein, um die Benetzung des hochschmelzenden Metalls durch das duktile Metall zu ermöglichen.

US 2002/100986 A1 befasst sich mit einer Technologie zur Realisierung von Lötverbindungen auf der Hochtemperaturseite in einer temperaturhierarchischen Verbindung. Ein Verbindungsteil zwischen einem Halbleiterbauelement und einem Substrat besteht aus Metallkugeln, wie z.B. Cu-Kugeln und einer Verbindung von Sn mit den Metallkugeln, und die Metallkugeln sind durch die Verbindung verbunden. Ein Primärsubstrat mit elektronischen Bauteilen ist auf einem Sekundärsubstrat, z. B. einer gedruckten Schaltung und einer Hauptplatine, in dem elektronischen Gerät angebracht. Die Verbindungen zwischen den elektronischen Bauteilen und dem Primärsubstrat werden durch Aufschmelzen einer Lötpaste mit den Cu-Kugeln und Sn-Lötkugeln hergestellt. Verbindungen zwischen dem Primärsubstrat und dem Sekundärsubstrat werden durch Aufschmelzen eines Sn-(2,0 bis 3,5) Masse-% Ag-(0,5 bis 1,0) Masse-% Cu-Lots hergestellt.

US 9,508,676 B1 bezieht sich auf eine Halbleitergehäusestruktur mit Hohlkammer und Bodensubstrat, sowie auf ein Gehäusungsverfahren.

Eine Halbleitergehäusestruktur mit einer Hohlkammer enthält ein Bodensubstrat mit einem Bodensockel und einer Bodenmetallschicht, die auf einem Anordnungsbereich des Bodensockels ausgebildet ist, eine Verbindungsschicht, die auf der Bodenmetallschicht ausgebildet ist, und ein oberes Substrat. Die untere Metallschicht hat mindestens eine Ecke mit einer ersten und einer zweiten äußeren Seitenfläche und eine äußere Verbindungsfläche. Eine erste Verlängerungslinie wird von einem ersten Extrempunkt der ersten äußeren Seitenfläche gebildet, und eine zweite Verlängerungslinie wird von einem zweiten Extrempunkt der zweiten äußeren Seitenfläche gebildet. Ein erster freiliegender Bereich der unteren Grundplatte wird durch Verbinden des ersten und zweiten Extrempunkts und eines Kreuzungspunkts des ersten und zweiten Extrempunkts gebildet. Das obere Substrat verbindet sich mit der Verbindungsschicht, um eine Hohlkammer zwischen dem oberen und dem unteren Substrat zu bilden.

Schließlich ist der Einsatz von Ultraschallenergie aus der Patentschrift US 6 659 329 B1 bekannt um die native Oxidschicht aufzubrechen. Dabei wird eine spezielles Lotmaterial ("aktives Löten"), spezielle Lötapparate und teilweise inerte Atmosphäre benötigt. Solche Apparate sind jedoch nur von Spezialfirmen erhältlich und vergleichsweise aufwendig (siehe z. B. soniKKs GmbH, *Ultraschall-Löten.* [Online] Available: https://www.sonikks.de/de/ultraschall-anwendungen/ultraschalllöten, Accessed on: July 2, 2019).

Es besteht daher ein Bedarf an einem Verfahren zum Fügen mindestens eines ersten und eines zweiten Fügebereichs, welches die Nachteile der bekannten Lösungen überwindet, so dass die gefertigten Fügeverbindungen sicher und zuverlässig sind, aber dennoch kostengünstig herstellbar sind. Weiterhin besteht ein Bedarf an einer derartigen Fügeverbindung, die insbesondere in der Lage ist, auf einfache Weise elektronische Bauteile innerhalb einer implantierbaren elektronischen Komponente hermetisch zu verkapseln.

Diese Aufgabe wird durch den Gegenstand der unabhängigen Patentansprüche gelöst. Vorteilhafte Ausführungsformen der vorliegenden Erfindung sind Gegenstand der abhängigen Patentansprüche.

Dabei basiert die vorliegende Erfindung auf der Idee, zum Ausbilden einer Weichlotverbindung, bei der einer der Fügepartner eine Oberfläche aus Titan oder einer Titanlegierung ist, eine Wolfram-Titan-Legierung oder Reintitan als Haftvermittler zwischen dem Titan- bzw. Titanlegierungsuntergrund und dem Weichlot zu verwenden. In vorteilhafter Weise wird bei der erfindungsgemäßen Haftvermittlerlegierung der Wolframhauptkomponente ein Titananteil zwischen 15 Gewichtsprozent und 5 Gewichtsprozent, vorzugsweise 10 Gewichtsprozent, zugesetzt.

Ein erster Aspekt der Erfindung umfasst ein Verfahren zum Fügen mindestens eines ersten und eines zweiten Fügebereichs entsprechend Anspruch 1, mit folgenden Schritten:
Aufbringen einer Haftvermittlerschicht in dem ersten Fügebereich, wobei der erste Fügebereich wenigstens teilweise eine metallische Oberfläche hat und wobei die Haftvermittlerschicht eine Wolfram-Titan-Schicht oder eine reine Titanschicht umfasst,
Bereitstellen des zweiten Fügebereichs, wobei der zweite Fügebereich wenigstens teilweise eine metallische Oberfläche hat,
Verlöten des ersten und zweiten Fügebereichs mittels einer Weichlotverbindung.

Dabei wird unter einer Weichlotverbindung eine Lötverbindung verstanden, die bei Temperaturen unter 450 °C herstellbar ist. Weichlote können dabei z. B. bleifreie Lote wie Sn Ag4, Sn Cu3 oder Sn Ag10 sein. Weiterhin können auch bleihaltige Weichlote wie z. B. Sn Pb40, Sn Pb38Cu2, Sn Pb50 oder Pb Sn40 verwendet werden. Insbesondere ein Zinnlot mit 4 Gewichtsprozent Silber (Sn Ag4), das einen Schmelzbereich von ca. 221 °C hat, ist bereits für die Verwendung in Medizinprodukten zugelassen. Es können aber auch alle anderen niedrigschmelzenden Lotlegierungen wie z. B. AgSn, AuSn, InSn oder SbSn mit Fließtemperaturen unter 450 °C verwendet werden.

Gemäß einer vorteilhaften Weiterbildung der vorliegenden Erfindung wird eine metallische Benetzungsschicht auf die Haftvermittlerschicht aufgebracht, bevor der Verlötungsschritt durchgeführt wird. Eine solche Benetzungsschicht verbessert die Benetzung der Oberfläche, auf welche das Weichlot aufgebracht wird. Die Benetzungsschicht enthält vorteilhaft Platin, Nickel, Palladium, Gold, Silber, Kupfer und/oder Zinn, vorzugsweise wird Platin verwendet.

In besonders vorteilhafter Weise wird die Haftvermittlerschicht mittels physikalischer Gasphasenabscheidung (physical vapour deposition, PVD), insbesondere in einem Sputterverfahren, aufgedampft. Wie dies bekannt ist, wird beim Sputtern, das auch als Kathodenzerstäubung bezeichnet wird, das Ausgangsmaterial (Target) durch lonenbeschuss zerstäubt und in die Gasphase überführt. Aus der Gasphase scheidet sich die Schicht dann auf dem zu beschichtenden Substrat ab.

Vorzugsweise weist die Haftvermittlerschicht eine Wolfram-Titan-Schicht, insbesondere eine W Ti10-Legierung, oder Reintitan auf. Dabei wird ein Target aus einer solchen W Ti10-Legierung oder Reintitan zerstäubt und die entsprechende Haftvermittlerschicht lagert sich auf dem Titan bzw. der Titanlegierung des Basismaterials der ersten Fügestelle ab. Andere Legierungsverhältnisse mit zwischen 15 und 5 Gewichtsprozent Titan in Wolfram sind selbstverständlich auch möglich. Wenn man als zweiten Fügepartner eine Keramik verwendet, muss nicht unbedingt dieselbe Wolfram-Titan-Schicht oder Reintitanschicht als Haftvermittlerschicht verwendet werden, es können alle für die Lötung auf Keramik üblichen Metallisierungen eingesetzt werden. Um jedoch ein symmetrisches Benetzungsverhalten und eine langzeitstabile hermetische Verbindung zu erreichen, ist es vorteilhaft, auf beiden Fügepartnern dieselbe Schichtfolge als Untergrund für das Weichlot zu verwenden.

Die Benetzungsschicht wird vorzugsweise ebenfalls in einem Sputterverfahren aufgebracht.

In vorteilhafter Weise wird der Schritt des Verlötens bei einer Temperatur von weniger als 450 °C durchgeführt. Wie bereits erwähnt, können viele Weichlote bereits bei unter 250 °C zum Schmelzen gebracht werden.

Die vorliegende Erfindung bezieht sich außerdem auf eine Fügeverbindung entsprechend Anspruch 5, wobei die Fügeverbindung einen ersten Fügebereich und einen zweiten Fügebereich aufweist, wobei der erste Fügebereich wenigstens teilweise eine metallische Oberfläche und eine darauf abgeschiedene Haftvermittlerschicht aufweist, wobei die Haftvermittlerschicht eine Wolfram-Titan-Legierungsschicht oder Reintitan umfasst, wobei der zweite Fügebereich wenigstens teilweise eine metallische Oberfläche hat, und wobei der erste und der zweite Fügebereich durch eine Weichlotverbindung miteinander verbunden sind.

Die vorteilhaften Eigenschaften der erfindungsgemäßen Haftvermittlerschicht kommen insbesondere dann zum Tragen, wenn die metallische Oberfläche des ersten Fügebereichs Titan und/oder eine Titanlegierung aufweist. Wie oben bereits ausgeführt, umfasst die Fügeverbindung in vorteilhafter Weise eine metallische Benetzungsschicht, die zwischen der Haftvermittlerschicht und der Weichlotverbindung angeordnet ist.

Die vorliegende Erfindung bezieht sich weiterhin auf eine elektronische Komponente entsprechend Anspruch 8, mit mindestens einem elektronischen Bauteil, einem ersten Gehäuseelement, in welchem das mindestens eine elektronische Bauteil wenigstens teilweise aufgenommen ist, und mindestens einem zweiten Gehäuseelement, wobei das erste Gehäuseelement und das mindestens eine zweite Gehäuseelement über eine Fügeverbindung gemäß der vorliegenden Erfindung miteinander verbunden sind, um das mindestens eine elektronische Bauteil hermetisch zu verkapseln, wobei der erste Fügebereich an dem ersten Gehäuseelement angeordnet ist und der zweite Fügebereich an dem zweiten Gehäuseelement angeordnet ist.

Beispielsweise weist das erste Gehäuseelement einen Hohlkörper auf, der wenigstens teilweise aus Titan und/oder einer Titanlegierung hergestellt ist, wie dies z. B. bei aktiven medizinischen Implantaten wie Herzschrittmachern zum Kapseln der elektronischen Bauteile benötigt wird. Damit durch das zweite Gehäuseelement hindurchgeführte elektrisch leitfähige Verbindungsleitungen auf einfache Weise voneinander isoliert werden können, kann das mindestens eine zweite Gehäuseelement wenigstens teilweise aus einem elektrisch isolierenden, vorzugsweise aus einem keramischen Material hergestellt sein. Keramische Materialien haben außerdem den Vorteil, dass sie inert, langzeitstabil und biokompatibel sind. Weichlötbare Metallisierungen können auf einfache Weise auf keramische Materialien aufgebracht werden.

Gemäß einer vorteilhaften Ausführungsform der vorliegenden Erfindung ist das keramische Material in dem zweiten Fügebereich mit einer Wolfram-Titan-Haftvermittlerschicht oder einer Reintitan-Haftvermittlerschicht und/oder einer metallischen Benetzungsschicht beschichtet. Die Haftvermittlerschicht und/oder die Benetzungsschicht können in beiden Fügebereichen identisch aufgebaut sein. Dies sorgt für eine weitgehende Symmetrie der Lötverbindung. Es ist aber klar, dass dies nicht zwingend so sein muss. Insbesondere muss auf dem keramischen Material nicht unbedingt eine Wolfram-Titan-Haftvermittlerschicht angeordnet sein, sondern es können alle anderen geeigneten weichlötbaren Metallisierungen vorgesehen sein.

Gemäß einem vorteilhaften Aspekt kann das erste Gehäuseelement mindestens eine Öffnung aufweisen, in welcher das mindestens eine zweite Gehäuseelement aufgenommen ist, so dass der erste Fügebereich den zweiten Fügebereich umlaufend um den Öffnungsrand umgibt. Durch ein solches Einpassen des zweiten Gehäuseelements in eine Außenfläche des ersten Gehäuseelements kann auf einfache Weise eine stabile und homogene Lötnaht zwischen zwei im Wesentlichen in einer Ebene befindlichen Fügebereichen erstellt werden. Auch kann durch das Fließverhalten des Weichlotes eine Stufe zwischen den Gehäuseelementen überwunden werden. Alternativ kann das erste Gehäuseelement mindestens eine Öffnung aufweisen, an welcher das mindestens eine zweite Gehäuseelement so angeordnet ist, dass der erste Fügebereich wenigstens teilweise an dem zweiten Fügebereich aufliegt. Ein solches Aufliegen des zweiten Gehäuseelements kann in bestimmten Fällen mechanisch leichter handhabbar sein, weil das erste Gehäuseelement das zweite Gehäuseelement abstützen kann.

Damit die elektronischen Bauelemente im Inneren des Gehäuses auf einfache Weise kontaktiert werden können, kann das mindestens eine zweite Gehäuseelement mindestens eine Leitungsdurchführung aufweisen, wobei mindestens eine elektrisch leitfähige Verbindungsleitung in der Leitungsdurchführung verlötet ist. Auch kann das zweite Gehäuseelement keine Leitungsdurchführung aufweisen und als Fenster für die Übertragung von elektromagnetischen (z. B. Funk-) Signalen in das erste Gehäuseelement eingebracht sein.

Die vorliegende Erfindung bezieht sich außerdem auf eine Schaltungsanordnung entsprechend Anspruch 15, mit einem Schaltungsträger und einer darauf angeordneten elektronischen Komponente mit der erfindungsgemäßen Fügeverbindung.

Zum besseren Verständnis der vorliegenden Erfindung wird diese anhand der in den nachfolgenden Figuren dargestellten Ausführungsbeispiele näher erläutert. Dabei werden gleiche Teile mit gleichen Bezugszeichen und gleichen Bauteilbezeichnungen versehen. Weiterhin können auch einige Merkmale oder Merkmalskombinationen aus den gezeigten und beschriebenen unterschiedlichen Ausführungsformen für sich eigenständige, erfinderische oder erfindungsgemäße Lösungen darstellen. Es zeigen:
- **Fig. 1**: eine schematische Schnittdarstellung einer Fügeverbindung gemäß einem ersten Aspekt der vorliegenden Erfindung;
- **Fig. 2**: eine schematische Schnittdarstellung einer Fügeverbindung gemäß einem weiteren Aspekt der vorliegenden Erfindung;
- **Fig. 3**: eine schematische Schnittdarstellung einer Fügeverbindung gemäß einem weiteren Aspekt der vorliegenden Erfindung;
- **Fig. 4**: eine schematische Schnittdarstellung einer elektronischen Komponente gemäß einem weiteren Aspekt der vorliegenden Erfindung;
- **Fig. 5** - 7: verschiedene Fertigungsstadien einer elektronischen Komponente gemäß einem weiteren Aspekt der vorliegenden Erfindung;
- **Fig. 8**: eine schematische Schnittdarstellung eines Teils einer elektronischen Komponente gemäß dem Stand der Technik.

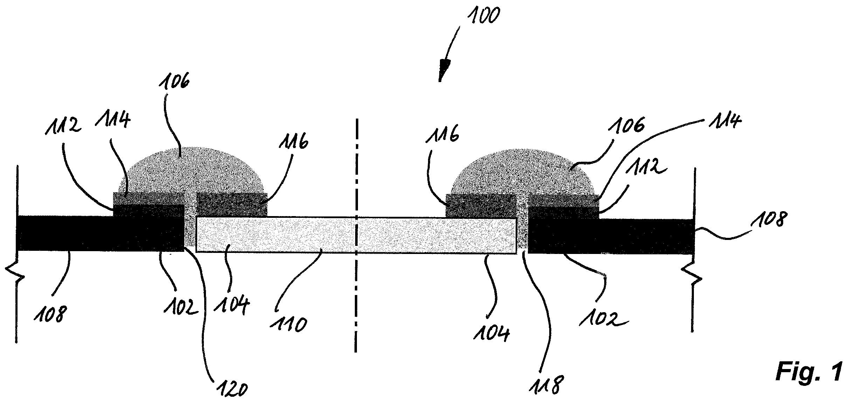

Die vorliegende Erfindung wird nachfolgend mit Bezug auf die Figuren, und dabei insbesondere zunächst mit Bezug auf die schematischen Schnittdarstellungen der Figur 1, näher erläutert. Es wird angemerkt, dass in sämtlichen Figuren die Größenverhältnisse und insbesondere die Schichtdickenverhältnisse nicht unbedingt maßstabsgetreu wiedergegeben sind.

Figur 1 zeigt in Form einer schematischen Schnittdarstellung eine Fügeverbindung 100 gemäß einem ersten Aspekt der vorliegenden Erfindung. Die Fügeverbindung 100 umfasst einen ersten Fügebereich 102 und einen zweiten Fügebereich 104, die über eine Weichlotverbindung 106 miteinander verbunden sind. Gemäß der vorliegenden Erfindung ist der erste Fügebereich 102 ein Teil eines inerten metallischen Basismaterials 108. Der zweite Fügebereich 104 ist Teil eines elektrisch nichtleitenden Materials 110.

Das inerte Basismaterial 108 kann Titan oder Titanlegierungen, z. B. Ti G4 (Reintitan) oder Ti G5 (Ti Al6 V4), oder andere inerte Metalle wie Legierungen auf Nickel-Kobalt-Basis, z. B. MP35N (Warenzeichen der SPS Technologies, LLC), Nickel-Titan-Legierungen, z. B. Nitinol, oder Edelstahl umfassen. Ein wesentliches Charakteristikum des inerten Basismaterials 108 ist entsprechend der Erfindung die Tatsache, dass eine unmittelbare Lötbarkeit mit einem Weichlot nicht gegeben ist. Erfindungsgemäß ist deshalb in einem peripheren Bereich des Fügebereichs 102 eine Haftvermittlerschicht 112 vorgesehen. Diese Haftvermittlerschicht 112 umfasst erfindungsgemäß eine Wolfram-Titan-Legierung oder Reintitan. Die Wolfram-Titan-Legierung kann durch Wolfram mit einem Anteil von 5 bis 25 Gewichtsprozent Titan gebildet sein. Vorzugsweise wird eine W Ti10 Legierung oder Reintitan mit einer Dicke von beispielsweise 50 nm verwendet. Es ist aber selbstverständlich auch möglich, dass die Haftvermittlerschicht neben Wolfram und Titan noch weitere Legierungsbestandteile enthält. Die Haftvermittlerschicht 112 ermöglicht es, dass ein Weichlot 106 für eine stabile hermetische Verbindung zu dem inerten metallischen Basismaterial 108 verwendet werden kann. Damit die Benetzung durch das Weichlot 106 erleichtert wird, ist optional eine Benetzungsschicht 114 zwischen der Haftvermittlerschicht 112 und dem Weichlot 106 vorgesehen. Die Benetzungsschicht 114 kann beispielsweise durch eine Platinschicht gebildet sein. Zum Beispiel kann diese Schicht 114 eine Dicke von 500 nm haben. Selbstverständlich können aber auch andere Materialien, die für eine verbesserte Benetzung sorgen, verwendet werden. Beispielsweise können Gold, Silber, Kupfer, Nickel, Nickel-Palladium, Palladium und Zinn-Bleilegierungen eingesetzt werden.

Zur Herstellung der erfindungsgemäßen Fügeverbindung 100 wird das metallische Basismaterial 108 zunächst mit Standardlösemitteln wie Azeton, Alkohol oder deionisiertem Wasser gereinigt. Anschließend wird das Basismaterial 108 in eine Hochvakuumkammer eingebracht und in einem Sputterverfahren mit der Haftvermittlerschicht 112 versehen. Wie bereits erwähnt, kann dies eine W Ti10-Schicht oder eine Reintitanschicht mit einigen Nanometern Dicke sein. Die optionale Benetzungsschicht 114 wird in derselben Anlage aufgebracht, indem ein anderes Target verwendet wird. Beispielsweise können mehrere 100 nm, vorzugsweise 500 nm, einer Platinschicht aufgedampft werden.

Das nichtleitende Material 110 ist im zweiten Fügebereich 104 ebenfalls mit einer Metallisierungsschicht 116 versehen. In der gezeigten Ausführungsform der Figur 1 unterscheidet sich der Schichtaufbau der Metallisierungsschicht 116 von dem Schichtaufbau in dem ersten Fügebereich 102. Insbesondere weist die Metallisierung Schicht 116 nur eine einfache Lage einer für Leiterbahnen auf Keramiksubstraten üblichen Metallisierung auf. Das elektrisch nichtleitende Material 110 kann beispielsweise aus Aluminiumoxidkeramik, Borosilikatglas oder jedem anderen geeigneten Isolator hergestellt sein. Die Metallisierung 116 wird entsprechend aus einer Molybdän-Mangan-Legierung, aus goldhaltigen Pasten, einer Wolfram-Titan-Legierung oder dergleichen hergestellt, die auch in die Keramik eingebrannt sein kann, wie dies für Keramiksubstrate bekannt ist.

Die Weichlotverbindung 106 verbindet sich zum einen mit der erfindungsgemäßen Haftvermittlerschicht 112 bzw. der optionalen Benetzungsschicht 114 im ersten Fügebereich 102 und mit der Metallisierungsschicht 116 im zweiten Fügebereich 104 andererseits und wird durch Kapillarkräfte in den Spalt 118 zwischen dem ersten Fügebereich 102 und dem zweiten Fügebereich 104 gezogen.

Die Weichlotverbindung 106 zwischen dem ersten Fügebereich 102 und dem zweiten Fügebereich 104 kann auf unterschiedliche Weise ausgebildet werden. Zum einen können ein handelsüblicher Lötdraht und ein Hand-Lötkolben eingesetzt werden. Weiterhin kann eine Lotpaste aufgebracht werden, die in einem Reflow-Ofen geschmolzen wird. Schließlich kann auch eine Lötfolie aufgebracht und im Reflow-Ofen geschmolzen werden. Allen Varianten ist gemeinsam, dass eine maximale Prozesstemperatur von 450 °C erreicht wird und an die Atmosphäre nur sehr geringe Anforderungen gestellt werden. Für den Einsatz in implantierten Komponenten wird anschließend eine Reinigung durchgeführt, um das beim Löten freigesetzte Flussmittel zu entfernen. Dies kann in einem Ultraschallbad mit leicht basischen Lösungen und anschließendem Spülen erfolgen.

Bei der in Figur 1 gezeigten Ausführungsform ist das elektrisch nichtleitende Material 110 in eine Öffnung 120 in dem inerten metallischen Basismaterial 108 unter Ausbildung des Spaltes 118 eingepasst. Auf diese Weise bilden die Oberflächen der beiden Fügebereiche 102, 104 eine im wesentlichen ebene Fläche, auf der die Lötnaht ausgebildet wird.

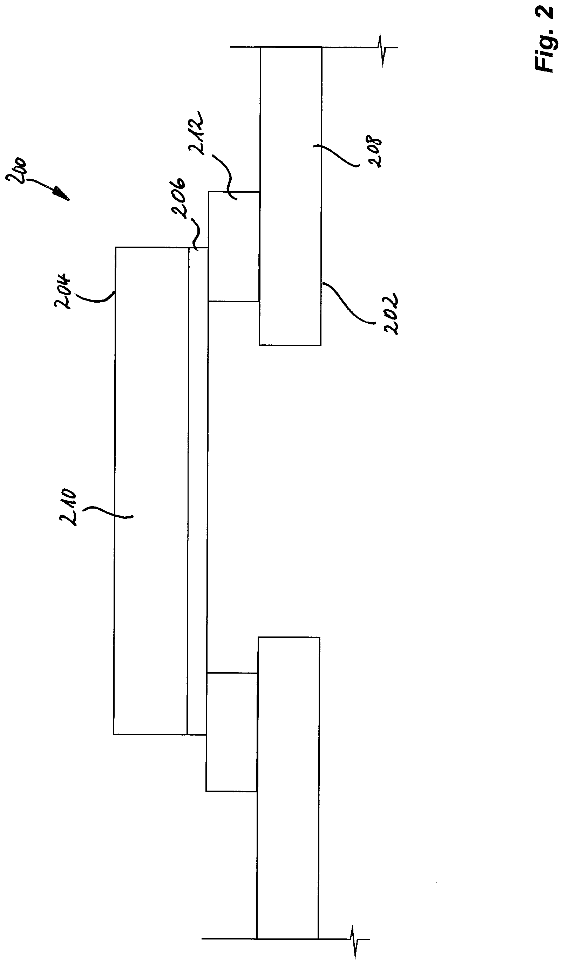

Diese Ausgestaltung erfordert eine Fixierung des elektrisch nichtleitenden Materials 110 in der Öffnung 120. Daher wird gemäß einem weiteren Aspekt der vorliegenden Erfindung die in Figur 2 gezeigte Ausgestaltung vorgeschlagen. Bei der Fügeverbindung 200 liegt der zweite Fügebereich 204 auf dem ersten Fügebereich 202 teilweise auf. Das elektrisch nichtleitende Material 210 ist beispielsweise durch eine Keramikplatte gebildet. Die Keramikplatte trägt an der dem ersten Lötbereich 202 zugewandten Oberfläche eine Lötfolie 206.

Zum Verbinden der Lötfolie 206 mit dem inerten metallischen Basismaterial 208 ist in dem ersten Fügebereich eine Haftvermittlerschicht 212, beispielsweise eine W Ti10-Legierungsschicht, angebracht.

Als amorphe Lötfolien werden eutektische Legierungen der Übergangsmetalle wie Nickel, Eisen, Kupfer oder dergleichen hergestellt, die Anteile der Halbmetalle Silizium und Bor, und/oder Phosphor enthalten. Amorphe Lötfolien werden in Form dünner Metallfolien oder daraus gefertigter Formteile angeboten. Diese Formteile können als abgelängte Folienstreifen, gestanzte oder photochemisch hergestellte Formteile für spezielle Anwendungen gefertigt werden. Die Folie wird im Lötofen unter Schutzgasatmosphäre oder im Vakuum verlötet. Bei konfektionierten Lötfolien werden Abfälle vermieden, und somit Material eingespart. Lötfolien oder Formteile eignen sich sehr gut, um in automatischen Montageprozessen implementiert zu werden. Über die Foliendicke, die fein variiert werden kann, ist es möglich, die benötigte Lotmenge exakt auf den speziellen Anwendungsfall einzustellen. Durch die Verwendung von Folien oder Formteilen aus Folie, die speziell für den Anwendungsfall konzipiert sind, werden Abfälle vermieden und die Produktionsgeschwindigkeit erhöht, was die Wirtschaftlichkeit des Lötprozesses erhöht. Insbesondere Lötfolien können Schichtsysteme enthalten, die für das moderne transiente Flüssigphasendiffusionsbonden (Transient-Liquid-Phase-Bonding, TLP) geeignet sind. Dieser Prozess ist ebenfalls als Niedrigtemperaturprozess einzustufen.

Die übrigen Aspekte und Arbeitsschritte entsprechen der Ausgestaltung aus Figur 1. Insbesondere kann auch eine zusätzliche (nicht dargestellte) Benetzungsschicht vorgesehen sein.

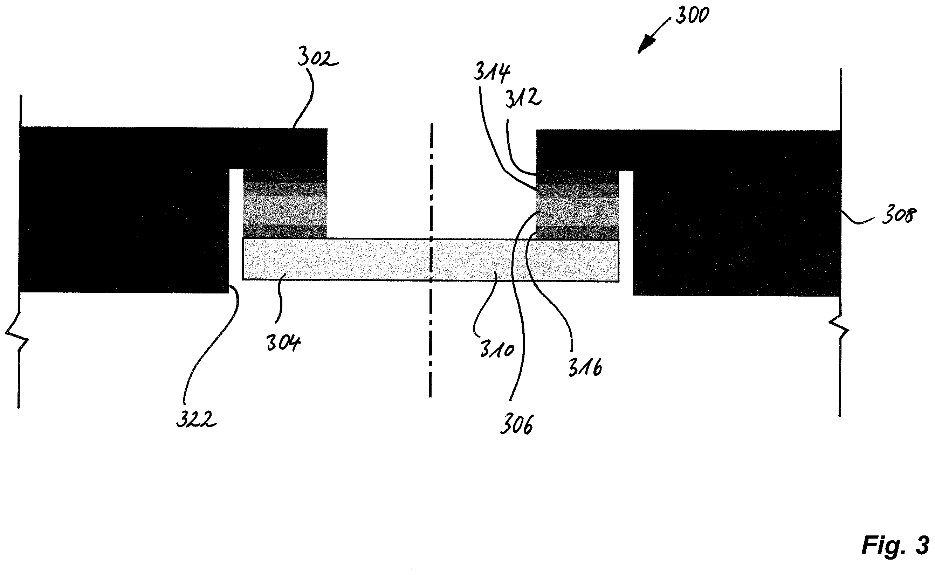

Eine weitere vorteilhafte Ausführungsform einer Fügeverbindung 300 zwischen einem ersten Fügebereich 302 und einem zweiten Fügebereich 304 ist in Figur 3 gezeigt. Gemäß dieser Ausführungsform überlappen der erste Fügebereich 302 und der zweite Fügebereich 304. Gleichzeitig ist das inerte metallische Basismaterial 108 dicker als das elektrisch nichtleitende Material 310, wobei der erste Fügebereich 302 Teil einer Ausnehmung 322 ist. Das elektrisch nichtleitende Material 310 ist in der Ausnehmung 322 so aufgenommen, dass es in dem metallischen Basismaterial 308 eingebettet ist. In dem ersten Fügebereich 302 ist das metallische Basismaterial 308 mit einer Wolfram-Titan-Haftvermittlerschicht 312 und einer optionalen Benetzungsschicht 314 versehen.

Das elektrisch nichtleitende Material 310, das z. B. durch ein keramisches Material oder Borosilikatglas gebildet ist, weist eine Metallisierungsschicht 316 auf.

In der gezeigten Ausführungsform ist die Weichlotverbindung 306 durch eine entsprechend strukturierte Lötfolie gebildet. Alle anderen oben erläuterten Varianten des Weichlötens können selbstverständlich auch bei dieser Ausführungsform zum Einsatz kommen.

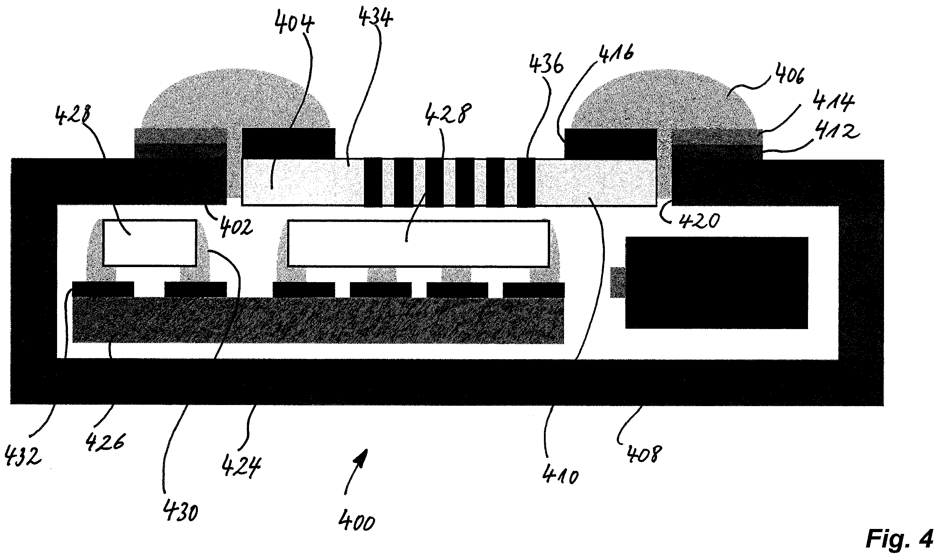

Fig. 4 zeigt in einer schematischen Schnittdarstellung ein Beispiel einer elektronischen Komponente 400 mit einer Weichlotverbindung 406. Ein inertes metallisches Basismaterial 408 bildet ein Gehäuse 424. Das Gehäuse 424 bildet einen Hohlraum, in dem ein Schaltungsträger 426 angeordnet ist. Der Schaltungsträger 426 ist mit elektronischen Bauteilen 428 bestückt. Dabei können die elektronischen Bauteile, wie dies schematisch angedeutet ist, über Reflow-Lötverbindungen 430 mit entsprechenden Leiterbahnen 432 auf dem Schaltungsträger 426 verbunden sein.

Die elektronische Komponente 400 kann beispielsweise ein aktives medizinisches Implantat wie zum Beispiel ein Herzschrittmacher sein. In diesem Fall handelt es sich bei dem inerten metallischen Basismaterial 408 um ein biokompatibles, die Elektronik abschirmendes Titan- oder Titanlegierungsgehäuse. Die erfindungsgemäße Fügetechnologie kommt zur Anwendung, um eine Durchführungseinheit 434 so mit dem Gehäuse 424 zu verlöten, dass die darin enthaltenen Bauteile hermetisch gekapselt sind, und gleichzeitig elektrische Durchführungen 436 für Anregungselektroden und Sensorsignalleitung bereitzustellen. Auch kann ein reines Keramik- oder Borosilikatsubstrat als Fenster für elektromagnetische Signale dienen.

Die Durchführungseinheit 434 weist ein elektrisch nichtleitendes Material 410 wie beispielsweise eine Aluminiumoxidkeramik, ein Borosilikatglas oder einen anderen mechanisch und chemisch stabilen Isolator auf. Der periphere Bereich der Durchführungseinheit 434 ist mit einer Metallisierung Schicht 416 versehen. Die Durchführungen 436 weisen Vias mit darin aufgenommenen Verbindungsleitungen (in der Figur nicht detailliert sichtbar) auf. Die Durchführungseinheit 434 kann weitestgehend vorkonfektioniert sein, bevor sie in die Öffnung 420 des Gehäuses 424 eingepasst wird. Das inerte Basismaterial 408 des Gehäuses 424 ist umlaufend um die Öffnung 420 mit einer Haftvermittlerschicht 412 und einer darauf abgeschiedenen Benetzungsschicht 414 versehen.

Dabei kann das Gehäuse 424 im noch nicht bestückten Zustand ebenso wie mit den darin aufgenommenen Bauteilen einem Sputterprozess unterworfen werden, um die Haftvermittlerschicht 412 und die Benetzungsschicht 414 abzuscheiden.

Der Umriss der Durchführungseinheit 434 kann jede beliebige Gestalt, z. B. rund, oval oder rechteckig, sein und folgt zweckmäßigerweise dem Umriss der Öffnung 420. Im Gegensatz zu herkömmlichen Hochtemperaturverfahren können durch die beschriebene Erfindung auch scharfe Knicke des Umrisses mit einer hermetischen Lötnaht 406 abgeschlossen werden.

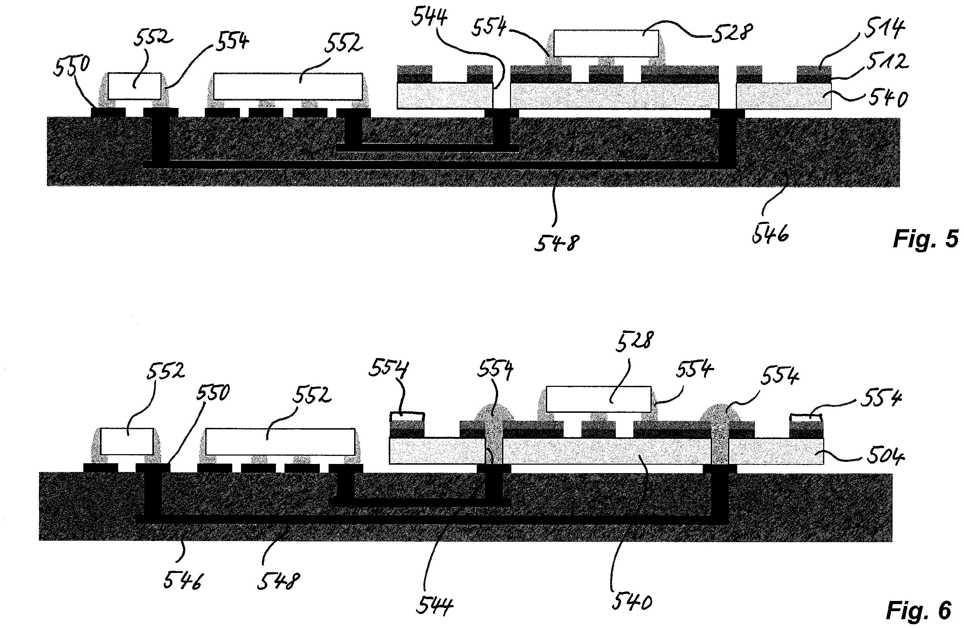

Die erfindungsgemäße Fügetechnik lässt sich aber auch zum hermetischen Abschließen von ausgewählten Teilen einer Schaltungsanordnung verwenden. Dies ist insbesondere vorteilhaft, wenn eine elektrische Abschirmung und/oder hermetische Kapselung bestimmter Schaltungskomponenten benötigt wird. Anhand der Figuren 5 bis 7 soll eine solche Schaltungsanordnung 500 gemäß einem weiteren Aspekt der vorliegenden Erfindung erläutert werden.

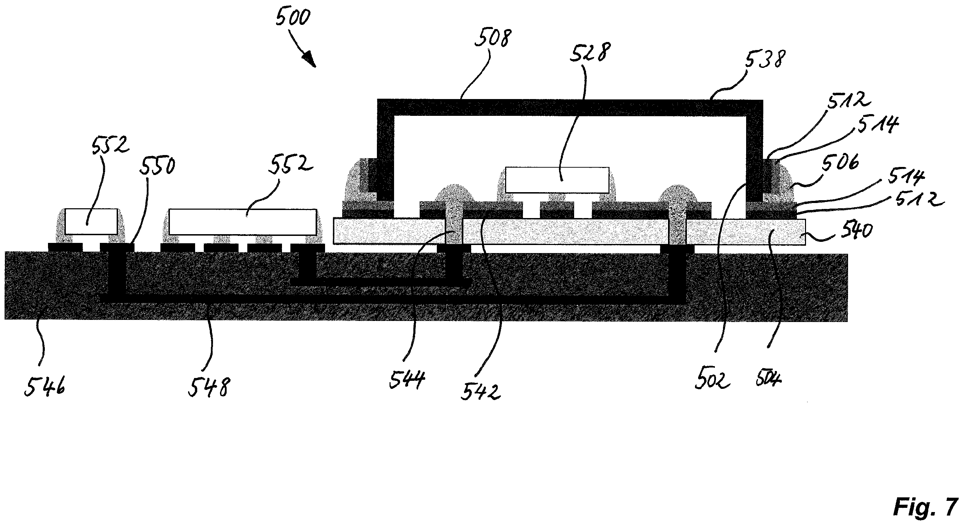

Betrachtet man zunächst die fertige Schaltungsanordnung 500, die in Figur 7 dargestellt ist, so umfasst die Schaltungsanordnung 500 eine Abdeckung 538, die aus einem inerten metallischen Basismaterial 508, wie beispielsweise Titan oder Edelstahl oder Nickel-Kobalt-Chrom Legierungen, besteht. Die Abdeckung 538 verkapselt mindestens ein erstes elektronisches Bauteil 528, das auf einem Keramiksubstrat 540 montiert ist. Das Keramiksubstrat 540 bildet somit den elektrisch nichtleitenden Fügepartner für die Fügeverbindung gemäß der vorliegenden Erfindung, während die Abdeckung 538 den inerten metallischen Fügepartner darstellt.

Um das elektronische Bauteil 528 hermetisch zu kapseln, ist eine Weichlotverbindung 506 umlaufend um die Abdeckung 538 angebracht. Die Weichlotverbindung 506 stellt eine Verbindung zwischen einem ersten Fügebereich 502, der in einem Randbereich der Abdeckung 538 angeordnet ist, und einem zweiten Fügebereich 504, der auf dem Keramiksubstrat 540 angeordnet ist, her.

Erfindungsgemäß ist in dem ersten Fügebereich 502 eine Haftvermittlerschicht 512 angeordnet, die beispielsweise eine Wolfram-Titanlegierungsschicht oder Reintitan aufweist, Insbesondere kann eine etliche Nanometer dicke W Ti10-Schicht oder eine Reintitanschicht mittels Sputterabscheidung aufgebracht sein. Um die Benetzung durch das Lot zu verbessern, kann außerdem optional zwischen der Haftvermittlerschicht 512 und der Lotschicht 506 eine Benetzungsschicht 514 vorgesehen sein. Die Benetzungsschicht 514 kann beispielsweise eine Platinschicht aufweisen.

Das Keramiksubstrat 540 weist im zweiten Fügebereich 504 in der gezeigten Ausführungsform dieselbe Schichtfolge, die aus einer Wolfram-Titanlegierung 512 und einer Platinschicht 514 gebildet ist, auf. Gemäß der gezeigten Ausführungsform wird diese Schichtfolge auch für die elektrischen Verbindungsleitungen 542 verwendet. Die elektrische Kontaktierung nach außen erfolgt über Vias 544, die durch das Keramiksubstrat 540 hindurch zu dessen Rückseite führen. Alternativ kann aber auch eine einfache Metallisierungsschicht analog zu der Ausführungsform der Figur 4 vorgesehen sein.

Weiterhin ist das Keramiksubstrat 540 mit dem darauf befindlichen hermetisch eingekapselten elektronischen Bauteil 528 auf einem Schaltungsträger 546 angeordnet. Der Schaltungsträger 546 kann beispielsweise eine herkömmliche gedruckte Leiterplatte, engl.: Printed Circuit Board (PCB), mit darin eingebetteten Leiterbahnen 548 und Kontaktpads 550 sein. Selbstverständlich kann der Schaltungsträger 546 auch flexible Leiterplatten oder Keramiksubstrate umfassen.

Weitere elektronische Bauteile 552 können außerhalb der hermetisch versiegelten Abdeckung 538 auf dem Schaltungsträger 546 angeordnet sein.

Die Weichlotverbindung 506 kann auch für die elektrische Kontaktierung dieser weiteren elektronischen Bauteile verwendet werden. Beispielsweise wird Sn Ag4 als Weichlot eingesetzt.

Ein beispielhafter Herstellungsprozess der Schaltungsanordnung 500 wird nachfolgend beginnend mit der Anordnung aus Figur 5 erläutert.

Zunächst wird ein Schaltungsträger 546, der beispielsweise ein Standard-PCB aus FR4 sein kann, in einem Bestückungsautomaten mit Lotpaste 554 und den elektronischen Bauteilen 552 bestückt. Ein Keramiksubstrat 540 trägt eine lötbare Schicht wie in Figur 4 gezeigt oder aber auch, wie in Figur 5 gezeigt, eine Metallisierung, die aus einer Wolfram-Titanlegierung 512 und einer Platin-Schicht 514 gebildet ist. Das Keramiksubstrat 540 wird ebenfalls mit Lotpaste 554 und mindestens einem elektronischen Bauteil 528 bestückt. Die Lotpaste 554 wird außerdem auch in die Vias 544 gefüllt (siehe Figur 6) und als ein Rahmen in dem zweiten Fügebereich 504 aufgebracht.

Die Abdeckung 538 wird als das metallische Basismaterial 508 zunächst mit Standardlösemitteln wie Azeton, Alkohol oder deionisiertem Wasser gereinigt. Anschließend wird das Basismaterial 508 in eine Hochvakuumkammer eingebracht und in einem Sputterverfahren mit der Haftvermittlerschicht 512 versehen. Wie bereits erwähnt, kann dies eine W Ti10-Schicht oder Reintitanschicht mit einigen Nanometern Dicke sein. Die optionale Benetzungsschicht 514 wird in derselben Anlage aufgebracht, indem ein anderes Target verwendet wird. Beispielsweise können mehrere 100 nm, vorzugsweise 500 nm, einer Platinschicht aufgedampft werden.

In einem nächsten Schritt wird die Abdeckung 538 auf den Rahmen aus Lotpaste 554 aufgesetzt. In einem gemeinsamen Reflowprozess werden alle Lotpasten aufgeschmolzen und es kommt zu den elektrischen Verbindungen an den elektronischen Bauteilen 528 und 552 wie auch zum Versiegeln der hermetischen Kapselung zwischen den Fügebereichen 502, 504.

Auf diese Weise wird eine Teilversiegelung in einem Standard-Pick-and-Place- und Reflowprozess ermöglicht. Dabei kann sowohl eine umschließende Metallhülle mit einzelnen Keramikscheiben zur elektromagnetischen Abschirmung der innen liegenden Teile verbaut werden, als auch ein hoher Keramikanteil mit einem Metallrahmen verbaut werden. Beiden Varianten ist gemeinsam, dass eine hermetische Verkapselung auf PCB-Ebene mit Werkzeugen und Materialien, die in jeder Standard-Elektronikfertigung verfügbar sind, erreicht werden kann.

Zusammenfassend löst gemäß einem vorteilhaften Aspekt die vorliegende Erfindung die oben beschriebene Problemstellung, indem das Titanmaterial bzw. die Titanlegierung in einer Sputteranlage mit z. B. mit W Ti10 als Haftvermittler und mit Platin als Benetzungsschicht bedampft wird. Die aufgebrachte Schicht stellt eine langzeitstabile und hermetische Verbindung zum Basismaterial bereit.

Die außenliegende Platinschicht kann durch bleihaltige und bleifreie Zinnlote (Weichlote mit Schmelzpunkt unter 450 °C) benetzt werden. Der Verbund, der das Basismaterial, eine W Ti10-Schicht oder Titanschicht, eine Platinschicht und das Zinnlot umfasst, ist wiederum stabil und hermetisch.

Für den hermetischen Abschluss zwischen Titan und Keramik, wie dies in jedem Herzschrittmacher verbaut ist, wird eine Weichlotverbindung zwischen dem Basismaterial und der Keramik ausgebildet. Der gesamte Verbund ist stabil und hermetisch. Die erfindungsgemäßen Fügestellen erlauben eine stabile Weichlotverbindung zu stark inertem Titan und Titanlegierungen. Der Fügeprozess kann unter Raumluftbedingungen und bei Temperaturen kleiner 450 °C stattfinden. Weiterhin beeinflusst der Fügeprozess die nativen Oxidschichten auf dem Basismaterial nicht. Schließlich kann ein hoher Freiheitsgrad in den möglichen Designs der Fügestellen erreicht werden.

Insgesamt bietet die vorliegende Erfindung die folgenden Vorteile.

Der aufgebrachte Schichtverbund benötigt außer einer sauber gereinigten Oberfläche keinerlei Vorbehandlung des Basismaterials.

Bei der Sputterabscheidung werden die Materialien nicht thermisch belastet.

Es tritt keine Oxidbildung beim Prozessieren auf, so dass keine Diffusion eines nativen Oxids in das Basismaterial auftritt.

Es treten keine Änderungen in der Phasenzusammensetzung des Basismaterials auf.

Diese Beschichtung findet zwingend nur auf dem Basismaterial des ersten Fügepartners statt. Der spätere Fügepartner muss nicht unbedingt in der Hochvakuumkammer bei der Sputterabscheidung mitprozessiert werden.

Das Design der Komponenten und Fügestellen muss nicht auf die Stressbelastung beim gemeinsamen Abkühlen von hohen Temperaturen über 450 °C angepasst werden.

Die Anforderungen an die Genauigkeit der Spaltmaße sind extrem niedrig.

Die Materialkosten, Maschinenkosten und Designkosten sind um ein Vielfaches niedriger als bei bisher üblichen Hochtemperaturprozessen.

### Bezugszeichenliste:

| **Bezugsziffer** | **Beschreibung** |
|---|---|
| 100, 200, 300 | Fügeverbindung |
| 102, 202, 302,402, 502 | Erster Fügebereich |
| 104, 204, 304, 404, 504 | Zweiter Fügebereich |
| 106, 206, 306, 406, 506 | Weichlotverbindung |
| 108, 208, 308, 408, 508 | Inertes metallisches Basismaterial |
| 110, 210, 310, 410 | Elektrisch nichtleitendes Material |
| 112, 212, 312, 412, 512 | Haftvermittlerschicht |
| 114, 214, 314, 414, 514 | Benetzungsschicht |
| 116, 316, 416 | Metallisierungsschicht |
| 118 | Spalt |
| 120, 420 | Öffnung |
| 322 | Ausnehmung |
| 400 | Elektronische Komponente |
| 424 | Gehäuse |
| 426 | Schaltungsträger |
| 428, 528 | Elektronisches Bauteil |
| 430 | Reflow-Lötverbindungen |
| 432 | Leiterbahn |
| 434 | Durchführungseinheit |
| 436 | Durchführung |
| 500 | Schaltungsanordnung |
| 538 | Abdeckung |
| 540 | Keramiksubstrat |
| 542 | Verbindungsleitungen |
| 544 | Via |
| 546 | Schaltungsträger |
| 548 | Leiterbahn |
| 550 | Kontaktpad |
| 552 | Weitere elektronische Bauteile |
| 554 | Lotpaste |
| 800 | Gehäuse |
| 802 | Erstes Gehäuseelement |
| 804 | Zweites Gehäuseelement |
| 806 | Verbindungsleitung |
| 808 | Leitungsdurchführung |
| 810 | Hochtemperaturmetalllegierung |

## Patentansprüche

1. Verfahren zum Fügen mindestens eines ersten und eines zweiten Fügebereichs (102, 104), wobei der erste Fügebereich (102) ein Teil eines inerten metallischen Basismaterials (108) ist, und wobei der zweite Fügebereich (104) ist Teil eines elektrisch nichtleitenden Materials (110), wobei ein wesentliches Charakteristikum eines inerten metallischen Materials die Tatsache ist, dass eine unmittelbare Lötbarkeit mit einem Weichlot nicht gegeben ist, wobei das inerte Basismaterial Titan oder Titanlegierungen, oder andere inerte Metalle wie Legierungen auf Nickel-Kobalt-Basis, Nickel-Titan-Legierungen, oder Edelstahl ist, wobei das Verfahren die folgenden Schritte aufweist:
Aufbringen einer Haftvermittlerschicht (112) auf die inerte metallische Oberfläche in dem ersten Fügebereich (102),
Bereitstellen des zweiten Fügebereichs (104), wobei der zweite Fügebereich (104) wenigstens teilweise eine metallische Oberfläche hat,
Verlöten des ersten und zweiten Fügebereichs (102, 104) mittels einer Weichlotverbindung (106),
**dadurch gekennzeichnet,**
**dass** die Haftvermittlerschicht (112) eine Wolfram-Titan-Legierungsschicht oder Reintitan umfasst.

2. Verfahren nach Anspruch 1, weiterhin umfassend den folgenden Schritt:
Aufbringen einer metallischen Benetzungsschicht (114), bevor der Verlötungsschritt durchgeführt wird.

3. Verfahren nach Anspruch 1 oder 2, wobei die Haftvermittlerschicht (112) und/oder die Benetzungsschicht (114) in einem Sputterverfahren aufgedampft wird, und/oder wobei die Wolfram-Titan-Legierungsschicht eine W Ti10-Legierung aufweist.

4. Verfahren nach einem der vorangehenden Ansprüche, wobei der Schritt des Verlötens bei einer Temperatur von weniger als 450 °C durchgeführt wird.

5. Fügeverbindung, die eine erste Komponente (108) mit einem ersten Fügebereich (102), eine zweite Komponente (110) mit einem zweiten Fügebereich (104),
und eine Weichlotverbindung (106) aufweist, wobei die erste Komponente (108) ein inertes metallisches Basismaterial ist, und die zweite Komponente (110) ein elektrisch nichtleitendes Material (110), wobei ein wesentliches Charakteristikum eines inerten metallischen Materials die Tatsache ist, dass eine unmittelbare Lötbarkeit mit einem Weichlot nicht gegeben ist, wobei das inerte Basismaterial Titan oder Titanlegierungen, oder andere inerte Metalle wie Legierungen auf Nickel-Kobalt-Basis, Nickel-Titan-Legierungen, oder Edelstahl ist,
wobei der erste Fügebereich (102) wenigstens teilweise die inerte metallische Oberfläche
und eine darauf abgeschiedene Haftvermittlerschicht (112) aufweist,
wobei der zweite Fügebereich (104) wenigstens teilweise eine metallische Oberfläche hat, und
wobei der erste und der zweite Fügebereich (102, 104) durch die Weichlotverbindung (106) miteinander verbunden (106) sind,
**dadurch gekennzeichnet,**
**dass** die Haftvermittlerschicht (112) eine Wolfram-Titan-Legierungsschicht oder Reintitan umfasst.

6. Fügeverbindung nach Anspruch 5, wobei die inerte metallische Oberfläche des ersten Fügebereichs (102) Titan und/oder eine Titanlegierung aufweist.

7. Fügeverbindung nach Anspruch 5 oder 6, weiterhin umfassend eine metallische Benetzungsschicht (114), die zwischen der Haftvermittlerschicht (112) und der Weichlotverbindung (106) angeordnet ist.

8. Elektronische Komponente mit mindestens einem elektronischen Bauteil (428), einem ersten Gehäuseelement (424), in welchem das mindestens eine elektronische Bauteil (428) wenigstens teilweise aufgenommen ist, und mindestens einem zweiten Gehäuseelement (434), **dadurch gekennzeichnet, dass** das erste Gehäuseelement und das mindestens eine zweite Gehäuseelement einer Fügeverbindung nach einem der Ansprüche 5 bis 7 entsprechen, um das mindestens eine elektronische Bauteil (428) hermetisch zu verkapseln, wobei der erste Fügebereich (402) an dem ersten Gehäuseelement (424) angeordnet ist und der zweite Fügebereich (404) an dem zweiten Gehäuseelement (434) angeordnet ist.

9. Elektronische Komponente nach Anspruch 8, wobei das erste Gehäuseelement (424) einen Hohlkörper aufweist, der wenigstens teilweise aus Titan und/oder einer Titanlegierung hergestellt ist.

10. Elektronische Komponente nach Anspruch 8 oder 9, wobei das mindestens eine zweite Gehäuseelement (434) wenigstens teilweise aus einem keramischen Material hergestellt ist.

11. Elektronische Komponente nach Anspruch 10, wobei das keramische Material in dem zweiten Fügebereich (404) mit einer Wolfram-Titan-Haftvermittlerschicht oder einer Reintitan-Haftvermittlerschicht und/oder einer metallischen Benetzungsschicht beschichtet ist.

12. Elektronische Komponente nach einem der Ansprüche 8 bis 11, wobei das erste Gehäuseelement mindestens eine Öffnung (420) aufweist, in welcher das mindestens eine zweite Gehäuseelement (434) aufgenommen ist, so dass der erste Fügebereich (402) den zweiten Fügebereich (404) umlaufend um den Öffnungsrand umgibt.

13. Elektronische Komponente nach einem der Ansprüche 8 bis 11, wobei das erste Gehäuseelement mindestens eine Öffnung aufweist, an welcher das mindestens eine zweite Gehäuseelement so angeordnet ist, dass der erste Fügebereich wenigstens teilweise an dem zweiten Fügebereich aufliegt.

14. Elektronische Komponente nach einem der Ansprüche 8 bis 13, wobei das mindestens zweite Gehäuseelement (434) mindestens eine Leitungsdurchführung (436) aufweist, und wobei mindestens eine elektrisch leitfähige Verbindungsleitung in der Leitungsdurchführung verlötet ist.

15. Schaltungsanordnung mit einem Schaltungsträger und **gekennzeichnet durch** eine darauf angeordnete elektronische Komponente nach einem der Ansprüche 8 bis 14.

## Claims

1. A method of joining at least a first and a second joining region (102, 104), wherein the first joining region (102) is part of an inert metallic base material (108), and wherein the second joining region (104) is part of an electrically non-conductive material (110), wherein an essential characteristic of an inert metallic material is the fact that direct solderability with a soft solder is not given, wherein the inert base material is titanium or titanium alloys, or other inert metals such as nickel-cobalt based alloys, nickel-titanium alloys, or stainless steel, the method comprising the following steps:
applying a bonding layer (112) to the inert metallic surface in the
first joining region (102), providing the second joining region (104), wherein the second joining region (104) has at least partially a metallic surface,
soldering the first and second joining regions (102, 104) by means of a soft solder joint (106),
**characterized in that**
the bonding layer (112) comprises a tungsten-titanium alloy layer or pure titanium.

2. The Method according to claim 1, further comprising the following step:
Applying a metallic wetting layer (114) before the soldering step is performed.

3. The method according to claim 1 or 2, wherein the bonding layer (112) and/or the wetting layer (114) is vapor-deposited in a sputtering process, and/or
wherein the tungsten-titanium alloy layer comprises a WTi10 alloy.

4. The Method according to one of the preceding claims, wherein the step of soldering is carried out at temperature of less than 450 °C.

5. A joint connection comprising a first component (108) having a first joining region (102), a second component (110) having a second joining region (104),
and a soft solder joint (106), wherein the first component (108) is an inert metallic base material, and the second component (110) is an electrically non-conductive material (110), wherein an essential characteristic of an inert metallic material is the fact that direct solderability with a soft solder is not given, wherein the inert base material is titanium or titanium alloys, or other inert metals such as nickel-cobalt-based alloys, nickel-titanium alloys, or stainless steel,
wherein the first joining region (102) at least partially covers the
inert metallic surface and an adhesion bonding layer (112) deposited thereon,
wherein the second joining region (104) has at least partially a metallic surface, and
wherein the first and second joining regions (102, 104)
are connected to one another by the soft solder joint (106),
**characterized in that** the bonding layer (112) comprises a tungsten-titanium alloy layer or pure titanium.

6. The joining connection according to claim 5, wherein the inert metallic surface of the first joining region (102) comprises titanium and/or a titanium alloy.

7. The joining connection according to claim 5 or 6, further comprising a metallic wetting layer (114) arranged between the adhesion bonding layer (112) and the soft solder joint (106).

8. An electronic component comprising at least one electronic component (428), a first housing element (424) in which the at least one electronic component (428) is at least partially accommodated, and at least one second housing element (434),
**characterized in**
**in that** the first housing element and the at least one second housing element correspond to a joint connection according to one of claims 5 to 7,
to hermetically encapsulate the at least one electronic component (428), wherein the first joining region (402) is arranged at the first housing element (424) and the second joining region (404) is arranged at the second housing element (434).

9. The electronic component according to claim 8, wherein the first housing element (424) comprises a hollow body which is at least partially made of titanium and/or a titanium alloy.

10. The electronic component according to claim 8 or 9, wherein the at least one second housing element (434) is at least partly made of a ceramic material.

11. The electronic component according to claim 10, wherein the ceramic material in the second joining region (404) is coated with a tungsten-titanium adhesion promoter layer or a pure titanium adhesion promoter layer and/or a metallic wetting layer.

12. The electronic component according to any one of claims 8 to 11, wherein the first housing element comprises at least one opening (420) in which the at least one second housing element (434) is received, so that the first joining region (402) surrounds the second joining area (404) circumferentially around the opening edge.

13. The electronic component according to any one of claims 8 to 11, wherein the first housing element comprises at least one opening at which the at least one second housing element is arranged such that the first joining region at least partially rests against the second joining area.

14. The electronic component according to any one of claims 8 to 13, wherein the at least second housing element (434) comprises at least one line feedthrough (436), and wherein at least one electrically conductive connecting line is soldered in the line feedthrough.

15. An circuit arrangement having a circuit carrier and **characterized by** an electronic component arranged thereon according to one of claims 8 to 14.

## Revendications

1. Procédé pour assembler au moins une première zone d'assemblage et une deuxième zone d'assemblage (102, 104), dans lequel la première zone d'assemblage (102) fait partie d'un matériau de base métallique inerte (108), et dans lequel la deuxième zone d'assemblage (104) fait partie d'un matériau électriquement non conducteur (110), dans lequel une caractéristique essentielle d'un matériau métallique inerte est le fait que la brasabilité directe avec une brasure tendre n'est pas possible, dans lequel le matériau de base inerte est du titane, un alliage de titane, ou un autre métal inerte tel qu'un alliage à base de nickel-cobalt, un alliage nickel-titane ou un acier inoxydable, dans lequel le procédé comporte les étapes suivantes :
application d'une couche d'adhésif (112) sur la surface métallique inerte dans la première zone d'assemblage (102),
fourniture de la deuxième zone d'assemblage (104), dans lequel la deuxième zone d'assemblage (104) comporte au moins partiellement une surface métallique,
brasure des première et deuxième zones d'assemblage (102, 104) à l'aide d'une connexion par brasure tendre (106),
**caractérisé en ce que** la couche d'adhésif (112) comporte une couche d'alliage tungstène-titane ou du titane pur.

2. Procédé selon la revendication 1, comprenant en outre l'étape suivante :
Application d'une couche de mouillage métallique (114) avant la mise en œuvre de l'étape de brasage.

3. Procédé selon la revendication 1 ou 2, dans lequel la couche d'adhésif (112) et/ou la couche de mouillage (114) est déposée en phase vapeur par un processus de pulvérisation cathodique, et/ou dans lequel la couche d'alliage tungstène-titane comporte un alliage W Ti10.

4. Procédé selon l'une des revendications précédentes, dans lequel l'étape de brasage est mise en œuvre à une température inférieure à 450 °C.

5. Connexion d'assemblage, comportant un premier composant (108) avec une première zone d'assemblage (102), un deuxième composant (110) avec une deuxième zone d'assemblage (104) et une connexion par brasure tendre (106), dans laquelle le premier composant (108) est un matériau de base métallique inerte, et le deuxième composant (110) est un matériau électriquement non conducteur (110), dans laquelle une caractéristique essentielle d'un matériau métallique inerte est le fait que la brasabilité directe avec une brasure tendre n'est pas possible, dans laquelle le matériau de base inerte est du titane, un alliage de titane, ou un autre métal inerte tel qu'un alliage à base de nickel-cobalt, un alliage nickel-titane ou un acier inoxydable, dans laquelle la première zone d'assemblage (102) comporte au moins partiellement la surface métallique inerte et une couche d'adhésif (112) qui y est déposée, dans laquelle la première zone d'assemblage (102) comporte au moins partiellement une surface métallique, et dans laquelle les première et deuxième zones d'assemblage (102, 104) sont connectées entre elles (106) via la connexion par brasure tendre (106),
**caractérisée en ce que** la couche d'adhésif (112) comprend une couche d'alliage de tungstène-titane ou du titane pur.

6. Connexion d'assemblage selon la revendication 5, dans laquelle la surface métallique inerte de la première zone d'assemblage (102) comporte du titane et/ou un alliage de titane.

7. Connexion d'assemblage selon la revendication 5 ou 6, comprenant en outre une couche de mouillage métallique (114) qui est agencée entre la couche d'adhésif (112) et la connexion par brasure tendre (106).

8. Composant électronique avec au moins un composant électronique (428), un premier élément de boîtier (424) dans lequel ledit au moins un composant électronique (428) est logé au moins partiellement, et au moins un deuxième élément de boîtier (434),
**caractérisé en ce que** le premier élément de boîtier et ledit au moins un deuxième élément de boîtier correspondent à une connexion d'assemblage selon l'une des revendications 5 à 7 afin d'encapsuler hermétiquement ledit au moins un composant électronique (428), dans lequel la première zone d'assemblage (402) est agencée sur le premier élément de boîtier (424) et la deuxième zone d'assemblage (404) est agencée sur le deuxième élément de boîtier (434).

9. Composant électronique selon la revendication 8, dans lequel le premier élément de boîtier (424) comporte un corps creux qui est au moins partiellement constitué de titane et/ou d'un alliage de titane.

10. Composant électronique selon la revendication 8 ou 9, dans lequel ledit au moins un deuxième élément de boîtier (434) est au moins partiellement constitué d'un matériau céramique.

11. Composant électronique selon la revendication 10, dans lequel le matériau céramique dans la deuxième zone d'assemblage (404) est recouvert d'une couche d'adhésif en tungstène-titane ou d'une couche d'adhésif en titane pur et/ou d'une couche de mouillage métallique.

12. Composant électronique selon l'une des revendications 8 à 11, dans lequel le premier élément de boîtier comporte au moins une ouverture (420) dans laquelle est logé au moins un deuxième élément de boîtier (434), de telle sorte que la première zone d'assemblage (402) entoure le deuxième zone d'assemblage (404) autour du bord d'ouverture.

13. Composant électronique selon l'une des revendications 8 à 11, dans lequel le premier élément de boîtier comporte au moins une ouverture au niveau de laquelle ledit au moins un deuxième élément de boîtier est agencé, de telle sorte que la première zone d'assemblage repose au moins partiellement sur la deuxième zone d'assemblage.

14. Composant électronique selon l'une des revendications 8 à 13, dans lequel ledit au moins un deuxième élément de boîtier (434) comporte au moins une traversée de câble (436) et dans lequel au moins une ligne de connexion électriquement conductrice est brasée dans la traversée de câble.

15. Agencement de circuit comportant un support de circuit, **caractérisé en ce qu'**un composant électronique selon l'une des revendications 8 à 14 y est agencé.
